# EUROPEAN PATENT APPLICATION

(11) **EP 4 474 533 A1**
(43) Date of publication of application: **11.12.2024**
(21) Application number: 23749497.6
(22) Date of filing: 17.01.2023
(51) Int. Cl.: C30B 29/16, C23C 16/40, C30B 25/02, H01L 21/365, H01L 21/368

(54) **CRYSTALLINE OXIDE FILM, MULTILAYER STRUCTURE, SEMICONDUCTOR DEVICE, AND METHOD FOR PRODUCING CRYSTALLINE OXIDE FILM**

(30) Priority: 02.02.2022 JP 2022014838
(71) Applicant: SHIN-ETSU CHEMICAL CO., LTD., Tokyo 1000005 (JP)
(72) Inventor: WATABE, Takenori, Annaka-shi, Gunma 379-0195 (JP); HASHIGAMI, Hiroshi, Annaka-shi, Gunma 379-0195 (JP); SAKATSUME, Takahiro, Annaka-shi, Gunma 379-0195 (JP)
(74) Representative: Sonnenhauser, Thomas Martin
(86) International application number: PCT/JP2023/001070
(87) International publication number: WO 2023/149180

(57) **Abstract**

The present invention is a crystalline oxide film containing gallium as a main component, in which when CuKα rays are made incident on the crystalline oxide film to perform X-ray diffraction, a reflection output in scanning ω and 2θ has a local maximum point when 16.20°<2θ<39.90° and 20.30°<ω<32.20° at an angle ϕ around a ϕ axis orthogonal to a surface of the crystalline oxide film at the angle ϕ where a peak attributable to the crystalline oxide film by ω-2θ measurement is maximum, and 40.10°<ω+θ<40.40° relative to ω and θ at which the reflection output reaches a maximum is satisfied. This provides the crystalline oxide film, a laminated structure, a semiconductor device with excellent semiconductor properties, particularly excellent withstand voltage, and a method for producing a crystalline oxide film.

## Description

### TECHNICAL FIELD

The present invention relates to a crystalline oxide film, a laminated structure, a semiconductor device, and a method for producing a crystalline oxide film.

### BACKGROUND ART

As a switching device for the next generation with achievable high withstand voltage, low losses, and high heat resistance, semiconductor devices using gallium oxide (Ga₂O₃) with a large band gap attract attention and are expected to be applied to power semiconductor devices, such as an inverter. Such gallium oxide can control a band gap by forming mixed crystals with indium or aluminum singly or in combination. Among all, InAlGaO-based semiconductors represented by In_{x'}Al_{y'}Ga_{z'}O₃ (0≤X'≤2, 0≤Y'≤2, 0≤Z'≤2, X'+Y'+Z'=1.5 to 2.5) are extremely attractive materials.

### CITATION LIST

### PATENT LITERATURE

Patent Document 1: JP 2013-028480 A
Patent Document 2: JP 2013-058637 A
Patent Document 3: WO 2016/013554 A1
Patent Document 4: JP 2018-129500 A

### SUMMARY OF INVENTION

### TECHNICAL PROBLEM

Patent Document 1 discloses a highly crystalline conductive α-Ga₂O₃ thin film with an added dopant (tetravalent tin). However, the thin film disclosed in Patent Document 1 is incapable of maintaining sufficient withstand voltage. This film also contains a large amount of carbon impurities and has unsatisfactory semiconductor properties, including conductivity, so the film is still difficult to use for a semiconductor device.

Patent Document 2 discloses a Ga₂O₃-based semiconductor device in which a p-type α-(AlₓGa₂₋ₓ)₂O₃ single crystal film is formed on an α-Al₂O₃ substrate. However, the semiconductor device disclosed in Patent Document 2 has many limitations to apply the semiconductor devices due to α-Al₂O₃ being an insulator or problematic quality of crystals. In addition, in an MBE method, ion implantation and heat treatment at high temperatures are necessary to obtain p-type semiconductors. Consequently, p-type α-Al₂O₃ itself is difficult to realize, and in fact, the semiconductor device disclosed in Patent Document 2 as such is difficult to realize.

As a response to these issues, in Patent Document 3, an SBD (Schottky barrier diode) using α-Ga₂O₃ having a thickness of 11.9 um is produced, thereby obtaining a withstand voltage of over 300 V. Although the method for producing the SBD disclosed in Patent Document 3 is a relatively easy method, it is required to make a film thickness thicker than necessary, and reproducibility (i.e., yield) has a problem therein.

In Patent Document 4, an SBD with a surface area of 1 mm square is produced, thereby obtaining a withstand voltage of over 855 V. However, the SBD disclosed in Patent Document 4 needs to use deuterated hydrobromic acid to produce α-Ga₂O₃, which is a semiconductor layer; thus, the problem is that it is economically unfeasible for industrialization.

An object of the present invention is to provide a crystalline oxide film, a laminated structure, and a semiconductor device with excellent semiconductor properties, particularly excellent withstand voltage while avoiding the above problems. Moreover, an object of the present invention is to provide a method for producing a crystalline oxide film that can produce the crystalline oxide film with excellent semiconductor properties, particularly excellent withstand voltage.

### SOLUTION TO PROBLEM

To solve the above problem, the present invention provides a crystalline oxide film containing gallium as a main component, wherein when CuKα rays are made incident on the crystalline oxide film to perform X-ray diffraction,
a reflection output in scanning ω and 2Θ has a local maximum point when 16.20°<2Θ<39.90° and 20.30°<ω<32.20° at an angle ϕ around a ϕ axis orthogonal to a surface of the crystalline oxide film at the angle ϕ where a peak attributable to the crystalline oxide film by ω-2θ measurement is maximum, and
40.10°<ω+θ<40.40° relative to ω and θ at which the reflection output reaches a maximum is satisfied.

In addition, the present invention provides a crystalline oxide film containing gallium as a main component, wherein when CuKα rays are made incident on the crystalline oxide film to perform X-ray diffraction,
a reflection output in scanning ω and 2Θ has a local maximum point when 26.20°<2Θ<49.90° and 25.30°<ω<37.20° at an angle ϕ around a ϕ axis orthogonal to a surface of the crystalline oxide film at the angle ϕ where a peak attributable to the crystalline oxide film by ω-2θ measurement is maximum, and
50.10°<ω+θ<50.40° relative to ω and θ at which the reflection output reaches a maximum is satisfied.

Moreover, the present invention provides a crystalline oxide film containing gallium as a main component, wherein when CuKα rays are made incident on the crystalline oxide film to perform X-ray diffraction,
a reflection output in scanning ω and 2Θ has a local maximum point when 12.00°<2Θ<35.70° and 18.20°<ω<30.10° at an angle ϕ around a ϕ axis orthogonal to a surface of the crystalline oxide film at the angle ϕ where a peak attributable to the crystalline oxide film by ω-2θ measurement is maximum, and
35.90°<ω+θ<36.20° relative to ω and θ at which the reflection output reaches a maximum is satisfied.

Furthermore, the present invention provides a crystalline oxide film containing gallium as a main component, wherein when CuKα rays are made incident on the crystalline oxide film to perform X-ray diffraction,
a reflection output in scanning ω and 2Θ has a local maximum point when 40.80°<2θ<64.50° and 32.60°<ω<44.50° at an angle ϕ around a ϕ axis orthogonal to a surface of the crystalline oxide film at the angle ϕ where a peak attributable to the crystalline oxide film by ω-2θ measurement is maximum, and
64.70°<ω+θ<65.00° relative to ω and θ at which the reflection output reaches a maximum is satisfied.

Such a crystalline oxide film described above can be obtained with high yield by a simple and easy process and has excellent crystallinity, and semiconductor properties, particularly withstand voltage, when applied to a semiconductor device. In addition, a surface smoothness of the crystalline oxide film is also excellent.

In addition, in the present invention, it is preferable that the crystalline oxide film has a surface area of 100 mm² or more or a diameter of 50 mm or more.

As a result, the crystalline oxide film having excellent crystallinity can be obtained over a large surface area.

Moreover, the present invention provides a laminated structure at least comprising:
an underlying substrate; and
the crystalline oxide film described above.

This provides the laminated structure having excellent crystallinity, and semiconductor properties, particularly withstand voltage, when applied to a semiconductor device. In addition, a surface smoothness of the film is also excellent.

Moreover, the present invention provides a semiconductor device comprising the crystalline oxide film described above.

This provides the semiconductor device having excellent semiconductor properties, particularly withstand voltage.

In addition, the present invention provides a method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2Θ has a local maximum point when 17.70°<2θ<41.40° and 21.00°<ω<32.90° at an angle ϕ around a ϕ axis orthogonal to a surface of the underlying substrate at the angle ϕ where a peak attributable to the crystalline oxide film by ω-2θ measurement is maximum, and
41.60°<ω+θ<41.90° relative to ω and θ at which the reflection output reaches a maximum is satisfied.

Moreover, the present invention provides a method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2Θ has a local maximum point when 28.60°<2θ<52.30° and 26.50°<ω<38.40° at an angle ϕ around a ϕ axis orthogonal to a surface of the underlying substrate at the angle ϕ where a peak attributable to the crystalline oxide film by ω-2θ measurement is maximum, and
52.50°<ω+θ<52.80° relative to ω and θ at which the reflection output reaches a maximum is satisfied.

Furthermore, the present invention provides a method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2Θ has a local maximum point when 13.80°<2Θ<37.50° and 19.10°<ω<31.00° at an angle ϕ around a ϕ axis orthogonal to a surface of the underlying substrate at the angle ϕ where a peak attributable to the crystalline oxide film by ω-2θ measurement is maximum, and
37.70°<ω+θ<38.00° relative to ω and θ at which the reflection output reaches a maximum is satisfied.

In addition, the present invention provides a method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2Θ has a local maximum point when 44.30°<2θ<68.00° and 34.30°<ω<46.20° at an angle ϕ around a ϕ axis orthogonal to a surface of the underlying substrate at the angle ϕ where a peak attributable to the crystalline oxide film by ω-2θ measurement is maximum, and
68.20°<ω+θ<68.50° relative to ω and θ at which the reflection output reaches a maximum is satisfied.

According to the method for producing a crystalline oxide film described above, the crystalline oxide film can be obtained by an easy and simple process with a high yield. Moreover, the crystalline oxide film can be obtained with excellent crystallinity, and semiconductor properties, particularly withstand voltage, when applied to a semiconductor device. In addition, the crystalline oxide film having a surface smoothness can be obtained.

### ADVANTAGEOUS EFFECTS OF INVENTION

As described above, the inventive crystalline oxide film has excellent crystallinity, and excellent semiconductor properties, particularly withstand voltage, when applied to a semiconductor device. In addition, a surface smoothness of the crystalline oxide film is also excellent. In addition, according to the inventive laminated structure, the laminated structure is provided with excellent crystallinity, and excellent semiconductor properties, particularly withstand voltage when applied to a semiconductor device. In addition, the surface smoothness of the film is also excellent. Moreover, a leakage current thereof is suppressed.

Furthermore, according to the inventive method for producing a crystalline oxide film, the crystalline oxide film can be obtained with excellent crystallinity, and excellent semiconductor properties, particularly withstand voltage when applied to a semiconductor device and also excellent surface smoothness.

### BRIEF DESCRIPTION OF DRAWINGS

FIG. 1 is a schematic configuration diagram illustrating an example of a semiconductor device using a laminated structure according to the present invention.
FIG. 2 is a schematic configuration diagram illustrating an example of a film-forming apparatus (a mist CVD apparatus) suitably used for forming a laminated structure according to the present invention.
FIG. 3 is a diagram describing an example of a mist-forming unit used for the present invention.
FIG. 4 is a conceptual diagram of an X-ray diffraction method according to the present invention.

### DESCRIPTION OF EMBODIMENTS

As described above, a crystalline oxide film having excellent withstand voltage is required to be provided.

The present inventors have earnestly studied the above problem and found out that a crystalline oxide film containing gallium as a main component can be obtained with high yield by a simple and easy process and has excellent crystallinity, and excellent semiconductor properties, particularly withstand voltage, when applied to a semiconductor device, in which the crystalline oxide film is provided that, when CuKα rays are made incident on the crystalline oxide film to perform X-ray diffraction, a reflection output in scanning ϕ, ω, and 2Θ has a local maximum point when 16.20°<2Θ<39.90° and 20.30°<ω<32.20°; and 40.10°<ω+θ<40.40° relative to ω and θ at which the reflection output reaches a maximum is satisfied. This finding has led to the completion of the present invention.

That is, the present invention is a crystalline oxide film containing gallium as a main component, in which when CuKα rays are made incident on the crystalline oxide film to perform X-ray diffraction, a reflection output in scanning ω and 2Θ has a local maximum point when 16.20°<2Θ<39.90° and 20.30°<ω<32.20° at an angle ϕ around a ϕ axis orthogonal to a surface of the crystalline oxide film at the angle ϕ where a peak attributable to the crystalline oxide film by ω-2θ measurement is maximum; and 40.10°<ω+θ<40.40° relative to ω and θ at which the reflection output reaches a maximum is satisfied.

The present inventors have earnestly studied the above problem and found out that the crystalline oxide film containing gallium as the main component can be obtained with high yield by a simple and easy process and has excellent crystallinity, and excellent semiconductor properties, particularly withstand voltage, when applied to a semiconductor device, in which the crystalline oxide film is provided that, when CuKα rays are made incident on the crystalline oxide film to perform X-ray diffraction, the reflection output in scanning ϕ, ω, and 2Θ has the local maximum point when 26.20°<2θ<49.90° and 25.30°<ω<37.20°; and 50.10°<ω+θ<50.40° relative to ω and θ at which the reflection output reaches a maximum is satisfied. This finding has led to the completion of the present invention.

That is, the present invention is a crystalline oxide film containing gallium as a main component, in which when CuKα rays are made incident on the crystalline oxide film to perform X-ray diffraction, a reflection output in scanning ω and 2Θ has a local maximum point when 26.20°<2Θ<49.90° and 25.30°<ω<37.20° at an angle ϕ around a ϕ axis orthogonal to a surface of the crystalline oxide film at the angle ϕ where a peak attributable to the crystalline oxide film by ω-2θ measurement is maximum; and 50.10°<ω+θ<50.40° relative to ω and θ at which the reflection output reaches a maximum is satisfied.

The present inventors have earnestly studied the above problem and found out that the crystalline oxide film containing gallium as the main component can be obtained with high yield by the simple and easy process and has excellent crystallinity, and excellent semiconductor properties, particularly withstand voltage, when applied to a semiconductor device, in which the crystalline oxide film is provided that, when CuKα rays are made incident on the crystalline oxide film to perform X-ray diffraction, the reflection output in scanning ϕ, ω, and 2Θ has the local maximum point when 12.00°<2θ<35.70° and 18.20°<ω<30.10°; and 35.90°<ω+θ<36.20° relative to ω and θ at which the reflection output reaches a maximum is satisfied. This finding has led to the completion of the present invention.

That is, the present invention is a crystalline oxide film containing gallium as a main component, in which when CuKα rays are made incident on the crystalline oxide film to perform X-ray diffraction, a reflection output in scanning ω and 2Θ has a local maximum point when 12.00°<2Θ<35.70° and 18.20°<ω<30.10° at an angle ϕ around a ϕ axis orthogonal to a surface of the crystalline oxide film at the angle ϕ where a peak attributable to the crystalline oxide film by ω-2θ measurement is maximum; and 35.90°<ω+θ<36.20° relative to ω and θ at which the reflection output reaches a maximum is satisfied.

The present inventors have earnestly studied the above problem and found out that the crystalline oxide film containing gallium as the main component can be obtained with high yield by a simple and easy process and has excellent crystallinity, and excellent semiconductor properties, particularly withstand voltage, when applied to a semiconductor device, in which the crystalline oxide film is provided that, when CuKα rays are made incident on the crystalline oxide film to perform X-ray diffraction, the reflection output in scanning ϕ, ω, and 2Θ has the local maximum point when 40.80°<2Θ<64.50° and 32.60°<ω<44.50°; and 64.70°<ω+θ<65.00° relative to ω and θ at which the reflection output reaches a maximum is satisfied. This finding has led to the completion of the present invention.

That is, the present invention is a crystalline oxide film containing gallium as a main component, in which when CuKα rays are made incident on the crystalline oxide film to perform X-ray diffraction, a reflection output in scanning ω and 2Θ has a local maximum point when 40.80°<2Θ<64.50° and 32.60°<ω<44.50° at an angle ϕ around a ϕ axis orthogonal to a surface of the crystalline oxide film at the angle ϕ where a peak attributable to the crystalline oxide film by ω-2θ measurement is maximum; and 64.70°<ω+θ<65.00° relative to ω and θ at which the reflection output reaches a maximum is satisfied.

In addition, the present inventors have earnestly studied the above problem and found out that by forming the crystalline oxide film on the sapphire substrate as the underlying substrate on which CuKα rays are made incident on the substrate to perform X-ray diffraction, the reflection output in scanning ϕ, ω, and 2Θ has the local maximum point when 17.70°<2θ<41.40° and 21.00°<ω<32.90°, and then 41.60°<ω+θ<41.90° relative to w and θ at which the reflection output reaches a maximum is satisfied; the crystalline oxide film can be produced, in which the reflection output in scanning w and 2Θ has the local maximum point when 16.20°<2Θ<39.90° and 20.30°<ω<32.20°; and 40.10°<ω+θ<40.40° relative to ω and θ at which the reflection output reaches a maximum is satisfied, with high yield by a simple and easy process, and the crystalline oxide film obtained has excellent crystallinity, and excellent semiconductor properties, particularly withstand voltage, when applied to a semiconductor device. This finding has led to the completion of the present invention.

That is, the present invention is a method for producing a crystalline oxide film containing gallium as a main component, the method includes forming the crystalline oxide film on a sapphire substrate as an underlying substrate, in which when CuKα rays are made incident on the underlying substrate to perform X-ray diffraction, a reflection output in scanning ω and 2Θ has a local maximum point when 17.70°<2θ<41.40° and 21.00°<ω<32.90° at an angle ϕ around a ϕ axis orthogonal to a surface of the underlying substrate at the angle ϕ where a peak attributable to the underlying substrate by ω-2θ measurement is maximum; and 41.60°<ω+θ<41.90° relative to ω and θ at which the reflection output reaches a maximum is satisfied.

In addition, the present inventors have earnestly studied the above problem and found out that by forming the crystalline oxide film on the sapphire substrate as the underlying substrate on which CuKα rays are made incident on the substrate to perform X-ray diffraction, the reflection output in scanning ϕ, ω, and 2Θ has the local maximum point when 28.60°<2Θ<52.30° and 26.50°<ω<38.40°, and then 52.50°<ω+θ<52.80° relative to w and θ at which the reflection output reaches a maximum is satisfied; the crystalline oxide film can be produced, in which the reflection output in scanning w and 2Θ has the local maximum point when 26.20°<2Θ<49.90° and 25.30°<ω<37.20°; and 50.10°<ω+θ<50.40° relative to ω and θ at which the reflection output reaches a maximum is satisfied, with high yield by a simple and easy process, and the crystalline oxide film obtained has excellent crystallinity and excellent semiconductor properties, particularly withstand voltage, when applied to a semiconductor device. This finding has led to the completion of the present invention.

That is, the present invention is a method for producing a crystalline oxide film containing gallium as a main component, the method includes forming the crystalline oxide film on a sapphire substrate as an underlying substrate, in which when CuKα rays are made incident on the underlying substrate to perform X-ray diffraction, a reflection output in scanning ω and 2Θ has a local maximum point when 28.60°<2Θ<52.30° and 26.50°<ω<38.40° at an angle ϕ around a ϕ axis orthogonal to a surface of the underlying substrate at the angle ϕ where a peak attributable to the underlying substrate by ω-2θ measurement is maximum; and 52.50°<ω+θ<52.80° relative to ω and θ at which the reflection output reaches a maximum is satisfied.

In addition, the present inventors have earnestly studied the above problem and found out that by forming the crystalline oxide film on the sapphire substrate as the underlying substrate on which CuKα rays are made incident on the substrate to perform X-ray diffraction, the reflection output in scanning ϕ, ω, and 2Θ has the local maximum point when 13.80°<2Θ<37.50° and 19.10°<ω<31.00°, and then 37.70°<ω+θ<38.00° relative to w and θ at which the reflection output reaches a maximum is satisfied; the crystalline oxide film can be produced, in which the reflection output in scanning w and 2Θ has the local maximum point when 12.00°<2Θ<35.70° and 18.20°<ω<30.10°; and 35.90°<ω+θ<36.20° relative to ω and θ at which the reflection output reaches a maximum is satisfied, with high yield by a simple and easy process, and the crystalline oxide film obtained has excellent crystallinity and excellent semiconductor properties, particularly withstand voltage, when applied to a semiconductor device. This finding has led to the completion of the present invention.

That is, the present invention is a method for producing a crystalline oxide film containing gallium as a main component, the method includes forming the crystalline oxide film on a sapphire substrate as an underlying substrate, in which when CuKα rays are made incident on the underlying substrate to perform X-ray diffraction, a reflection output in scanning ω and 2Θ has a local maximum point when 13.80°<2Θ<37.50° and 19.10°<ω<31.00° at an angle ϕ around a ϕ axis orthogonal to a surface of the underlying substrate at the angle ϕ where a peak attributable to the underlying substrate by ω-2θ measurement is maximum; and 37.70°<ω+θ<38.00° relative to ω and θ at which the reflection output reaches a maximum is satisfied.

In addition, the present inventors have earnestly studied the above problem and found out that by forming the crystalline oxide film on the sapphire substrate as the underlying substrate on which CuKα rays are made incident on the substrate to perform X-ray diffraction, the reflection output in scanning ϕ, ω, and 2Θ has the local maximum point when 44.30°<2θ<68.00° and 34.30°<ω<46.20°, and then 68.20°<ω+θ<68.50° relative to w and θ at which the reflection output reaches a maximum is satisfied; the crystalline oxide film can be produced, in which a reflection output in scanning ω and 2Θ has the local maximum point when 40.80°<2Θ<64.50° and 32.60°<ω<44.50°; and 64.70°<ω+θ<65.00° relative to ω and θ at which the reflection output reaches a maximum is satisfied, with high yield by a simple and easy process, and the crystalline oxide film obtained has excellent crystallinity, and excellent semiconductor properties, particularly withstand voltage, when applied to a semiconductor device. This finding has led to the completion of the present invention.

That is, the present invention is a method for producing a crystalline oxide film containing gallium as a main component, the method includes forming the crystalline oxide film on a sapphire substrate as an underlying substrate, in which when CuKα rays are made incident on the underlying substrate to perform X-ray diffraction, a reflection output in scanning ω and 2Θ has a local maximum point when 44.30°<2θ<68.00° and 34.30°<ω<46.20° at an angle ϕ around a ϕ axis orthogonal to a surface of the underlying substrate at the angle ϕ where a peak attributable to the underlying substrate by ω-2θ measurement is maximum; and 68.20°<ω+θ<68.50° relative to ω and θ at which the reflection output reaches a maximum is satisfied.

Hereinafter, the present invention will be described in detail. However, the present invention is not limited thereto.

### (Crystalline Oxide Film)

In a crystalline oxide film according to the first invention of the present application, a reflection output in scanning ϕ, ω, and 2Θ has a local maximum point when 16.20°<2θ<39.90° and 20.30°<ω<32.20° when CuKα rays are made incident to perform X-ray diffraction.

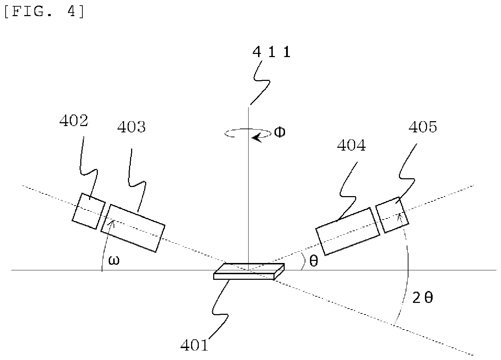

FIG. 4 shows a conceptual diagram of an X-ray diffraction according to the present invention. An X-ray source 402 is to generate CuKα rays (wavelength 1.5418 Å). An X-ray is made incident to a sample surface of sample 401 through an incidence optical element 403 at an angle ω, and then a reflected X-ray is detected by a detector 405 through a receptive optical element 404 at angle θ relative to the sample surface (a parameter to be controlled is usually 2Θ, twice a value of θ). A ϕ axis 411 is orthogonal to the sample surface and rotates the sample around the ϕ axis 411 for an angle ϕ while maintaining the sample surface horizontal. When a sample rotation mechanism is absent in an apparatus, the sample may be manually rotated appropriately.

First, the first invention of the present application performs a normal ω-2θ measurement (ω and 2θ are scanned simultaneously as ω=θ) in a state where a slit of the detector 405 is widened. In a state of capturing a peak attributable to a crystalline oxide film, scanning is performed where the ϕ is varied from 0 to 90°, and ϕ, where a detected intensity reaches a maximum, is searched. Next, the ϕ is fixed at which the detected intensity is the maximum, and then the slit of the detector 405 is narrowed, and then each of 2Θ in a range of 15° to 45°, for example, and w in a range of 15° to 35°, for example, are scanned independently. Next, after rotating 180° from ϕ, where the detected intensity reaches the maximum, 2Θ and ω are scanned again. A maximum reflection intensity (reflection output) in this case has the local maximum point when 16.20°<2Θ<39.90° and 20.30°<ω<32.20°; and 40.10°<ω+θ<40.40° relative to ω and θ at which the reflection output reaches a maximum.

The second invention of the present application is a crystalline oxide film in which when the same measurement described above is performed, a maximum reflection intensity (reflection output) has a local maximum point when 26.20°<2Θ<49.90° and 25.30°<ω<37.20°; and 50.10°<ω+θ<50.40° relative to ω and θ at which the reflection output reaches a maximum is satisfied.

The third invention of the present application is a crystalline oxide film in which when the same measurement described above is performed, a maximum reflection intensity (reflection output) has a local maximum point when 12.00°<2Θ<35.70° and 18.20°<ω<30.10°; and 35.90°<ω+θ<36.20° relative to ω and θ at which the reflection output reaches a maximum is satisfied.

The fourth invention of the present application is a crystalline oxide film in which when the same measurement described above is performed, a maximum reflection intensity (reflection output) has a local maximum point when 40.80°<2Θ<64.50° and 32.60°<ω<44.50°; and 64.70°<ω+θ<65.00° relative to ω and θ at which the reflection output reaches a maximum is satisfied.

Due to an exclusion of θ=ω in any of the crystalline oxide films, it is suggested that a film plane is not parallel to a crystal plane. Consequently, it is considered that the crystalline oxide film is less likely to have a generation of a crystal defect that penetrates perpendicularly to the film plane, resulting in excellent crystallinity and excellent withstand voltage when applied to semiconductor devices.

When each of ω, 2Θ, ω+θ is out of the above range, a withstand voltage yield is decreased and thus unpreferable.

A crystal structure of the crystalline oxide film is not particularly limited and may be a β-gallia structure, a corundum structure, or an orthorhombic crystal. That of the film may be a mixture of a plurality of crystal structures or a polycrystal, but a single crystal or a uniaxially oriented film is preferred.

In addition, the crystalline oxide film according to the present invention is a crystalline oxide film containing gallium as a main component. In general, an oxide film is constituted of a metal and oxygen, but in the crystalline oxide film according to the present invention, it is only required that gallium is used as the metal for a main component. Note that, in the present invention, "gallium as a main component" means gallium constitutes 50 to 100 atom% of metal components. The metal components other than gallium may include one or two or more metals selected from, for example, iron, indium, aluminum, vanadium, titanium, chromium, rhodium, iridium, nickel, and cobalt.

A dopant element may be included in the crystalline oxide film. For example, n-type dopants such as tin, germanium, silicon, titanium, zirconium, vanadium, or niobium, or p-type dopants such as copper, silver, tin, iridium, rhodium, or magnesium can be exemplified and not particularly limited. A concentration of the dopant may be, for example, about 1×10¹⁶/cm³ to 1×10²²/cm³, or may be a low concentration of about 1×10¹⁷/cm³ or less, or a high concentration of about 1×10²⁰/cm³ or more.

A film thickness of the crystalline oxide film is not particularly limited, but 1 um or more is preferable. The upper limit thereof is not particularly limited. The thickness may be, for example, 100 um or less, and can be preferably 50 um or less, and more preferably 20 um or less.

A size of the crystalline oxide film is not particularly restricted, but it is preferable to have a surface area of the crystalline oxide film of 100 mm² or more or a diameter of 2 inches (50mm) or more, because the film having excellent crystallinity and large surface can be obtained.

Such a crystalline oxide film according to the present invention can be obtained with high yield by a simple and easy process as described later.

### (Laminated Structure)

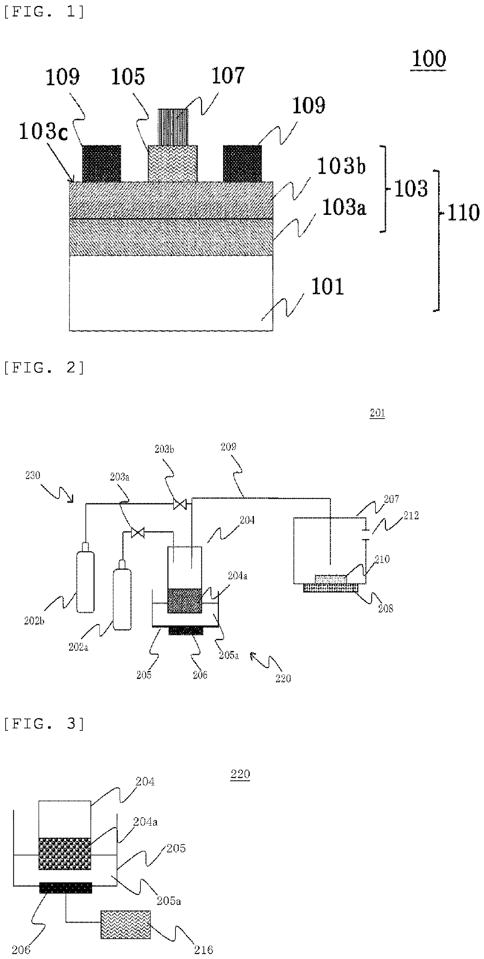

Any of the crystalline oxide films described above, together with the underlying substrate, may form the laminated structure. FIG. 1 shows a suitable example of a semiconductor device 100 in which a laminated structure 110 according to the present invention is used. As shown in FIG. 1, the laminated structure 110 according to the present invention has an underlying substrate 101 and any of a crystalline oxide films 103 described above.

Another layer may intervene between the underlying substrate 101 and the crystalline oxide film 103. Another layer is the layer having a different composition from the underlying substrate 101 and the crystalline oxide film 103 that is on the outermost surface, and this layer is also referred to as a buffer layer. The buffer layer may be any of the crystalline oxide film, a semiconductor film, an insulator film, a metal film, or the like. As a material, for example, Al₂O₃, Ga₂O₃, Cr₂O₃, Fe₂O₃, In₂O₃, Rh₂O₃, V₂O₃, Ti₂O₃, or Ir₂O₃, or the like are suitably used and a solid solution thereof may be used. The buffer layer has a thickness of preferably 0.1 um to 2 µm.

### (Underlying Substrate)

The underlying substrate 101 in the laminated structure 110 according to the present invention is not particularly limited as long as the substrate is suitable for growing the crystalline oxide film 103 described above and servable as a support. When the crystalline oxide film is bonded to the underlying substrate to form the laminated structure, a material thereof is not particularly limited, and a known substrate may be used; the material may be an organic compound or may be an inorganic compound. For Example, polysulfone, polyethersulfone, polyphenylene sulfide, polyetheretherketone, polyimide, polyetherimide, fluororesin, metals such as iron, aluminum, stainless steel, and gold, quartz, glass, calcium carbonate, gallium oxide, and ZnO are exemplified. In addition to these, single-crystal substrates such as silicon, sapphire, lithium tantalate, lithium niobate, SiC, GaN, iron oxide, and chromium oxide are exemplified, and single-crystal substrates such as the above are desirable for the laminated structure 110 according to the present invention. In this way, better quality crystalline oxide film 103 can be obtained. In particular, a sapphire substrate, a lithium tantalate substrate, and a lithium niobate substrate are relatively inexpensive and industrially advantageous.

As a detailed description is given later, when the crystalline oxide film is grown on the underlying substrate, the underlying substrate that is suitable for the growth is selected.

It is preferable that the underlying substrate has a thickness of 100 to 5000 um. With such a range, handling is easy, and a good-quality film can be easily obtained because thermal resistance can be suppressed during the forming.

### (Example of Constitution of Semiconductor Device)

In the example of the semiconductor device 100 shown in FIG. 1, the crystalline oxide film 103 is formed on the underlying substrate 101. The crystalline oxide film 103 is constituted by an insulator thin film 103a and a conductive thin film 103b laminated in this order from the underlying substrate 101 side. A gate insulator film 105 is formed on the conductive thin film 103b. A gate electrode 107 is formed on the gate insulator film 105. In addition, a source-drain electrode 109 is formed on the conductive thin film 103b so as to sandwich the gate electrode 107. According to such a constitution, a depletion layer formed in the conductive thin film 103b can be controlled by a gate voltage applied to the gate electrode 107, and thus transistor action (FET device) is enabled.

As a semiconductor device formed by using the laminated structure according to the present invention, the transistor such as an MIS, a HEMT, an IGBT, and the like; a TFT, a Schottky barrier diode using semiconductor-metal junction, a PN or PIN diode combined with other P layers, and a light receiving and light emitting device is exemplified. The laminated structure according to the present invention is useful for improving characteristics of these devices.

Such a laminated structure described above can be formed by known methods such as an evaporation method, an MBE method, a sputtering method, a CVD method, a mist CVD method, and a liquid phase epitaxy.

Methods for producing a crystalline oxide film and a laminated structure according to the present invention are described below using the mist CVD method as an example. Note that, the mist in the present invention is a generic term for fine liquid particles dispersed in a gas, including those called fog, droplets, etc.

### (Film Forming Apparatus)

First, a film forming apparatus (mist CVD apparatus), used in the mist CVD method suitable for producing the laminated structure according to the present invention, is described. FIG. 2 shows an example of a film forming apparatus 201 used in the mist CVD method. The film forming apparatus 201 includes at least a mist-forming unit 220 for forming a raw material solution 204a into the mist to generate the mist; a carrier gas supply unit 230 for supplying a carrier gas to transport the mist; a supply pipe 209 connecting the mist-forming unit 220 and a film forming chamber 207 to transport the mist by the carrier gas; and the film forming chamber 207 for heat treating the mist supplied with the carrier gas from the supply pipe 209 to form on the underlying substrate 210.

### (Mist-Forming Unit)

In the mist-forming unit 220, the raw material solution 204a is formed into the mist to generate the mist. The mist-forming method is not particularly limited as long as the raw material solution 204a can be formed into the mist. A known mist-forming means may be applicable, but the mist-forming means using ultrasonic vibrations is preferable. This is because stabler mist-forming can be performed.

FIG. 3 shows an example of such a mist-forming unit 220. The mist-forming unit 220 may include a mist-generating source 204 accommodating the raw material solution 204a therein; a container 205 that can accommodate a medium capable of transmitting ultrasonic vibrations, for example, water 205a; and an ultrasonic vibrator 206 attached on the bottom surface of the container 205. In detail, the mist generating source 204 made of a container accommodating the raw material solution 204a can be accommodated with a support (not shown) in the container 205 accommodating water 205a. The ultrasonic vibrator 206 may be provided on the bottom of the container 205, and the ultrasonic vibrator 206 and an oscillator 216 may be connected. In addition, it can be constituted that when the oscillator 216 is operated, the ultrasonic vibrator 206 is vibrated to propagate the ultrasonic waves into the mist generating source 204 via water 205a, and thus the raw material solution 204a is formed into the mist.

### (Raw Material Solution)

The material contained in the raw material solution 204a may be inorganic or organic material, and the material contained in the solution is not particularly limited as long as gallium is contained therein and the solution can be formed into the mist. As materials contained other than gallium, a metal or a metal compound is suitably used, and those containing one or two or more metals selected from iron, indium, aluminum, vanadium, titanium, chromium, rhodium, nickel, and cobalt may be used, for example. As the above raw material solution, the metal dissolved or dispersed in an organic solvent or water in a form of a complex or a salt can be suitably used. As a form of salt, for example, halogenated salts such as metal chloride salt, metal bromide salt, and metal iodide salts can be exemplified. In addition, the above metals dissolved in, for example, hydrogen halides such as hydrobromic acid, hydrochloric acid, and hydroiodic acid can also be used as a salt solution. As a form of complex, for example, acetylacetonate complex, carbonyl complex, ammine complex, hydride complex and the like are exemplified. The acetylacetonate complex can also be formed by mixing acetylacetone with the salt solution described above. A metal concentration in the raw material solution 204a is not particularly limited and can be 0.005 to 1 mol/L, etc. A temperature during mixing and dissolving is preferably 20°C or higher.

The raw material solution may be mixed with additives such as hydrohalic acid and an oxidizing agent. As hydrohalic acid, for example, hydrobromic acid, hydrochloric acid, and hydroiodic acid are exemplified, of which hydrobromic acid or hydroiodic acid is preferred. As an oxidizing agent, for example, peroxides such as hydrogen peroxide (H₂O₂), sodium peroxide (Na₂O₂), barium peroxide (BaO₂), benzoyl peroxide (C₆H₅CO)₂O₂; organic peroxides such as hypochlorous acid (HClO), perchloric acid, nitric acid, ozone water, peracetic acid, and nitrobenzene are exemplified.

The raw material solution may contain a dopant. The type of dopant is not particularly limited. For example, n-type dopants such as tin, germanium, silicon, titanium, zirconium, vanadium, or niobium, or p-type dopants such as copper, silver, iridium, rhodium, or magnesium are exemplified.

### (Carrier Gas Supply Unit)

As shown in FIG. 2, the carrier gas supply unit 230 has a carrier gas source 202a to supply the carrier gas. In this case, a flow regulating valve 203a may be provided to regulate a flow rate of the carrier gas delivered from the carrier gas source 202a. Moreover, the supply unit can be provided as needed with a diluent carrier gas source 202b to supply diluent carrier gas or a flow regulating valve 203b to regulate the flow rate of the diluent carrier gas delivered from the diluent carrier gas source 202b.

A type of carrier gas is not particularly limited and can be selected as appropriate for a film to be formed. For example, oxygen, ozone, inert gases such as nitrogen and argon, as well as reducing gases such as hydrogen gas and forming gas, are exemplified. In addition, the type of carrier gas may be one type or two or more types. For example, a diluted gas in which the same gas as a first carrier gas is diluted with another gas (e.g., diluted 10 times) may be further used as the second carrier gas, or air may be used. The flow rate of the carrier gas is not particularly limited. For example, when film-formation is performed on a substrate having a diameter of 2 inches (about 50 mm), the flow rate of the carrier gas is preferably 0.05 to 50 L/min and more preferably 5 to 20 L/min.

### (Supply Pipe)

The film forming apparatus 201 has the supply pipe 209 to connect the mist-forming unit 220 and the film forming chamber 207. In this case, the mist is transported by the carrier gas from the mist generating source 204 of the mist-forming unit 220 via the supply pipe 209 and supplied into the film forming chamber 207. For example, a quartz tube, a glass tube, and a tube made of resin can be used for the supply pipe 209.

### (Film Forming Chamber)

The underlying substrate 210 is placed in the film forming chamber 207, where a heater 208 can be provided to heat the underlying substrate 210. The heater 208 may be provided on an outside of the film forming chamber 207 as shown in FIG. 2 or may be provided on an inside of the film forming chamber 207. The mist supplied from the supply pipe 209 passes through the piping in the film forming chamber 207 and is sprayed with carrier gas from a nozzle onto the underlying substrate 210. Moreover, the film forming chamber 207 may be provided with an exhaust port 212 for exhaust gas at a position where the mist supply to the underlying substrate 210 is not affected. Furthermore, the underlying substrate 210 may be placed on a top surface of the film forming chamber 207, for example, to make the substrate face down, or the underlying substrate 210 may be placed on a bottom surface of the film forming chamber 207 to make the substrate face up.

### (Underlying Substrate)

It is preferable that an underlying substrate used for film growth is an underlying substrate in which maximum reflection intensity (reflection output) appears (having a local maximum point) at a certain range of 2Θ and w when ϕ, ω, and 2θ are scanned with CuKα rays as X-rays generated from the X-ray source as described above.

Specifically, when sapphire is used for the underlying substrate, it is acceptable to use the substrate in which the maximum reflection intensity appears when 17.70°<2θ<41.40° and 21.00°<ω<32.90°. In this case, 41.60°<ω+θ<41.90° is preferable. By using such an underlying substrate, the crystalline oxide film can be produced in which a reflection output in scanning ω and 2Θ has a local maximum point when 16.20°<2Θ<39.90° and 20.30°<ω<32.20°; and 40.10°<ω+θ<40.40° relative to ω and θ at which the reflection output reaches a maximum is satisfied.

In addition, when sapphire is used for the underlying substrate, it is acceptable to use the substrate in which the maximum reflection intensity appears when 28.60°<2Θ<52.30° and 26.50°<ω<38.40°. In this case, 52.50°<ω+θ<52.80° is preferable. By using such an underlying substrate, the crystalline oxide film can be produced in which a reflection output in scanning ω and 2Θ has a local maximum point when 26.20°<2θ<49.90°and 25.30°<ω<37.20°; and 50.10°<ω+θ<50.40° relative to ω and θ at which the reflection output reaches a maximum is satisfied.

Moreover, when sapphire is used for the underlying substrate, it is acceptable to use the substrate in which the maximum reflection intensity appears when 13.80°<2Θ<37.50° and 19.10°<ω<31.00°. In this case, 37.70°<ω+θ<38.00° is preferable. By using such an underlying substrate, the crystalline oxide film can be produced in which a reflection output in scanning ω and 2Θ has a local maximum point when 12.00°<2Θ<35.70° and 18.20°<ω<30.10°; and 35.90°<ω+θ<36.20° relative to ω and θ at which the reflection output reaches a maximum is satisfied.

Furthermore, when sapphire is used for the underlying substrate, it is acceptable to use the substrate in which the maximum reflection intensity appears at 44.30°<2θ<68.00° and 34.30°<ω<46.20°. In this case, 68.20°<ω+θ<68.50° is preferable. By using such an underlying substrate, the crystalline oxide film can be produced in which a reflection output in scanning ω and 2Θ has a local maximum point when 40.80°<2Θ<64.50° and 32.60°<ω<44.50°; and 64.70°<ω+θ<65.00° relative to ω and θ at which the reflection output reaches a maximum is satisfied.

In addition, when lithium tantalate is used for the underlying substrate, it is acceptable to use the substrate in which the maximum reflection intensity appears at 15.20°<2θ<38.90° and 19.80°<ω<31.70°. In this case, 39.10°<ω+θ<39.40° is preferable. Also, by using such an underlying substrate, the crystalline oxide film can be produced in which a reflection output in scanning ω and 2Θ has a local maximum point when 16.20°<2Θ<39.90° and 20.30°<ω<32.20°; and 40.10°<ω+θ<40.40° relative to ω and θ at which the reflection output reaches a maximum is satisfied.

Moreover, when lithium tantalate is used for the underlying substrate, it is acceptable to use the substrate in which the maximum reflection intensity appears at 24.50°<2θ<48.30° and 24.40°<ω<36.40°. In this case, 48.40°<ω+θ<48.80° is preferable. Also, by using such an underlying substrate, the crystalline oxide film can be produced in which a reflection output in scanning ω and 2Θ has a local maximum point when 26.20°<2Θ<49.90° and 25.30°<ω<37.20°; and 50.10°<ω+θ<50.40° relative to ω and θ at which the reflection output reaches a maximum is satisfied.

Furthermore, when lithium tantalate is used for the underlying substrate, it is acceptable to use the substrate in which the maximum reflection intensity appears at 10.80°<2θ<34.50° and 17.60°<ω<29.50°. In this case, 34.70°<ω+θ<35.00° is preferable. Also, by using such an underlying substrate, the crystalline oxide film can be produced in which a reflection output in scanning ω and 2Θ has a local maximum point when 12.00°<2Θ<35.70° and 18.20°<ω<30.10°; and 35.90°<ω+θ<36.20° relative to ω and θ at which the reflection output reaches a maximum is satisfied.

In addition, when lithium tantalate is used for the underlying substrate, it is acceptable to use the substrate in which the maximum reflection intensity appears at 38.40°<2θ<62.10° and 31.40°<ω<43.30°. In this case, 62.30°<ω+θ<62.60° is preferable. Also, by using such an underlying substrate, the crystalline oxide film can be produced in which a reflection output in scanning ω and 2Θ has a local maximum point when 40.80°<2Θ<64.50° and 32.60°<ω<44.50°; and 64.70°<ω+θ<65.00° relative to ω and θ at which the reflection output reaches a maximum is satisfied.

By forming the film using such an underlying substrate, the film can be grown inheriting from information of the underlying substrate, and the crystalline oxide film according to the present invention can be obtained. Such an underlying substrate can be obtained, for example, by providing a substrate with a finely varied plane orientation of the film-forming surface of the underlying substrate and selecting such an underlying substrate described above by X-ray diffraction measurement.

### (Film Forming Method)

Next, an example of a method for producing the laminated structure according to the present invention is described referring to FIG. 2. Broadly speaking, the mist CVD method includes a step of generating the mist by forming the material solution into the mist, in which the solution contains gallium, in a mist forming unit; a step of supplying the carrier gas to supply the carrier gas, which transports the mist, to the mist-forming unit; a step of transporting to transport the mist by the carrier gas from the mist-forming unit to the film forming chamber via a supply pipe connecting the mist-forming unit and a film forming chamber; and a step of film forming in which the mist transported is heat treated to form a film on an underlying substrate.

The raw material solution 204a mixed as described above is accommodated in the mist generating source 204, the underlying substrate 210 is placed in the film forming chamber 207, and then the heater 208 is operated. Next, flow regulating valves 203a and 203b are opened to supply the carrier gas from the carrier gas source 202a and the diluent carrier gas source 202b into the film forming chamber 207, and then an atmosphere in the film forming chamber 207 is sufficiently replaced with the carrier gas, after that, the flow rates of the carrier gas and the flow rate of the diluent carrier gas are adjusted, respectively.

Next, as the step of generating the mist, the ultrasonic vibrator 206 is vibrated, and the vibration is propagated to the raw material solution 204a through the water 205a to form the raw material solution 204a into the mist and generate the mist.

Next, as a step of supplying the carrier gas, the carrier gas for transporting the mist is supplied to the mist-forming unit 220.

Next, as a step of transporting, the mist is transported by the carrier gas from the mist-forming unit 220 to the film forming chamber 207 via the supply pipe 209 connecting the mist-forming unit 220 to the film forming chamber 207.

Next, as a step of film forming, the mist transported to the film forming chamber 207 is heated to generate a thermal reaction, thereby forming the film on a part of or an entire surface of the underlying substrate 210.

The thermal reaction requires that the reaction of gallium and the like contained in the mist proceed by heating. Therefore, it is required to make a temperature of the substrate surface at the time of the reaction at least 400°C or higher. Unlike other CVD methods, the mist CVD method requires making the raw material reach the underlying substrate surface in the form of liquid in the mist shape. Consequently, the temperature of the underlying substrate surface drops significantly. Thus, the temperature of the underlying substrate surface during the reaction is different from a preset temperature of the apparatus. It is preferable to measure and control the temperature of the underlying substrate surface during the reaction as well; however, when such a method is difficult, the temperature can be measured to substitute by making a simulation of the state of the reaction by, for example, introducing only carrier gas or water mist containing no solutes.

Moreover, the thermal reaction also depends on a temperature of the environment surrounding the underlying substrate. Consequently, a temperature of a nozzle or an inner wall of the film forming chamber is desirably higher than a room temperature. This is because the thermal reaction described above is stabilized. For example, the nozzle temperature can be 50 to 250°C.

Note that the thermal reaction may be performed in any atmosphere of a vacuum, a non-oxygen atmosphere, a reducing gas atmosphere, an air atmosphere, and an oxygen atmosphere, and may be determined appropriately depending on the film to be formed. Moreover, a reaction pressure can be under any conditions of atmospheric pressure, pressurized pressure, or depressurized pressure, but the film forming under atmospheric pressure is preferable because an apparatus configuration is simplified.

### (Formation of Buffer Layer)

As described above, the buffer layer may be provided between the underlying substrate and the crystalline oxide film as appropriate. A forming method of the buffer layer is not particularly limited, and the layer can be formed by known methods such as the sputtering method or a deposition method. However, in a case where the mist CVD method described above is used, the layer can be formed by changing the raw material solution as appropriate, thus making the formation thereof simple and easy. Specifically, one or two or more metals selected from aluminum, gallium, chromium, iron, indium, rhodium, vanadium, titanium, and iridium, dissolved or dispersed in water in the form of complexes or salts, can be suitably used as a raw material aqueous solution. As a form of the complex, for example, an acetylacetonate complex, a carbonyl complex, an ammine complex, a hydride complex, and the like are exemplified. As a form of salt, for example, metal chloride salt, metal bromide salt, metal iodide salt, and the like are exemplified. The above metals dissolved in hydrobromic acid, hydrochloric acid, hydroiodic acid, and the like can also be used as an aqueous salt solution. Also, in this case, a solute concentration is preferably 0.005 to 1 mol/L, and a dissolution temperature is preferably 20°C or higher. Also, about other conditions, the buffer layer can be formed by making the conditions the same as described above. After the buffer layer is formed to have a predetermined thickness, the film forming is performed by the above method.

A special case in the buffer layer forming method is a case in which the same material with the crystalline oxide film is used. In this case, a forming temperature of the buffer layer may be higher than a forming temperature of the crystalline oxide film. For example, the forming temperature of the buffer layer may be 450°C and the forming temperature of the crystalline oxide film 400°C, or that of the buffer layer forming may be 500°C and the crystalline oxide film 450°C. This further improves the crystallinity of the crystalline oxide film.

### (Heat Treatment)

In addition, the laminated structure according to the present invention may be heat treated at 200 to 600°C. As a result, unreacted species and the like in the crystalline oxide film are further removed, and a higher-quality laminated structure can be obtained. The heat treatment may be performed in air, an oxygen atmosphere, or an inert gas atmosphere such as nitrogen or argon. The heat treatment time is determined as appropriate and can be, for example, 5 to 240 minutes.

### (Delamination)

In the laminated structure according to the present invention, the crystalline oxide film may be delaminated from the underlying substrate. A delaminating means is not particularly limited and may be a known means. As a method for the delaminating means, for example, means to delaminate by applying mechanical shock, means to delaminate by applying heat to utilize thermal stress, means to delaminate by applying vibration such as an ultrasonic wave, and means to delaminate by etching are exemplified. By such a delamination, the crystalline oxide film can be obtained as a freestanding film.

### (Other Producing Method)

Although the mist CVD method is used as an example to describe the method for producing the crystalline oxide film according to the present invention, the crystalline oxide film according to the present invention can also be produced by methods other than the mist CVD method. In this way, the inventive crystalline oxide film can be obtained with high yield by a simple and easy process.

### EXAMPLE

Hereinafter, the present invention will be specifically described with reference to Examples and Comparative Example. However, the present invention is not limited thereto.

### [Example 1]

With reference to FIG. 2, a film forming apparatus 201 used in this Example is described. The film forming apparatus 201 was provided with a carrier gas source 202a to supply a carrier gas; a flow regulating valve 203a to regulate a flow rate of the carrier gas delivered from the carrier gas source 202a; a diluent carrier gas source 202b to supply a diluent carrier gas; a flow regulating valve 203b to regulate a flow rate of the diluent carrier gas delivered from the diluent carrier gas source 202b; a mist generating source 204 storing raw material solution 204a therein; a container 205 accommodating water 205a therein; an ultrasonic vibrator 206 attached on a bottom surface of the container 205; a film forming chamber 207 including a heater 208; and a supply pipe 209 made of quartz connecting the mist generating source 204 to the film forming chamber 207.

### (Underlying Substrate )

As an underlying substrate 210, a sapphire substrate having 4 inches (100mm) was provided. A ω-2θ measurement was performed on this substrate using an X-ray diffractometer; in a state of capturing a peak attributable to the underlying substrate, an angle ϕ was scanned, in which an angle ϕ was an angle around a ϕ axis orthogonal to a surface of the underlying substrate 210, and then the ϕ was fixed where ϕ had a maximum detected intensity, and then each of 2Θ and w was scanned independently, resulting in a detection output reached maximum when ω=24.86° and 2θ=33.72°. At this time, ω+θ was 41.72°.

### (Formation of n⁺ Gallium Oxide Film)

This underlying substrate 210 was placed in the film forming chamber 207, the heater 208 was set to 450°C, the temperature was raised, and the chamber was left for 30 minutes to stabilize the temperature inside the film forming chamber including a nozzle.

As for the raw material solution 204a, ultrapure water was used as the solvent, and gallium bromide as the solute. A gallium concentration in the raw material solution was set to 0.1 mol/L, and tin bromide was mixed so as to make the atomic ratio of tin to gallium 1:0.08. This raw material solution 204a was accommodated in the mist generating source 204. Subsequently, the flow regulating valves 203a and 203b were opened to supply the carrier gas from the carrier gas source 202a and the diluent carrier gas source 202b into the film forming chamber 207. After an atmosphere in the film forming chamber 207 was sufficiently replaced with the carrier gas, the flow rate of the carrier gas was adjusted to 2 L/min and the flow rate of the diluent carrier gas to 6 L/min. Nitrogen was used as the carrier gas and the diluent carrier gas.

Next, the ultrasonic vibrator 206 was vibrated at 2.4 MHz, and the vibration was propagated through the water 205a to the raw material solution 204a to form the raw material solution 204a into the mist to generate the mist. This mist was introduced into the film forming chamber 207 through the supply pipe 209 by the carrier gas, and the mist was thermally reacted on the underlying substrate 210 to form a thin film made of gallium oxide on the underlying substrate 210. The forming time was 180 minutes.

### (Evaluation)

Regarding the thin film formed on the underlying substrate 210, the formation of α-Ga₂O₃ was confirmed by X-ray diffraction. In addition, the film thickness was measured with an optical interferotype film thickness meter and was 7.8 µm.

### (Formation of n⁻ Gallium Oxide Film)

Subsequently, a film forming of an n⁻ gallium oxide film was performed. As the underlying substrate 210, n⁺ type semiconductor film which was delaminated from the sapphire substrate was placed in the film forming chamber 207, and then the heater 208 was set to 450°C, the temperature was raised, and the chamber was left for 30 minutes to stabilize the temperature in the film forming chamber including the nozzle.

As for the raw material solution 204a, ultrapure water was used as the solvent, and gallium bromide as the solute. A gallium concentration in the raw material solution was set to 0.1 mol/L. This raw material solution 204a was accommodated in the mist generating source 204. Subsequently, the flow regulating valves 203a and 203b were opened to supply the carrier gas from the carrier gas source 202a and the diluent carrier gas source 202b into the film forming chamber 207. After an atmosphere in the film forming chamber 207 was sufficiently replaced with the carrier gas, the flow rate of the carrier gas was adjusted to 2 L/min and the flow rate of the diluent carrier gas to 6 L/min. Nitrogen was used as the carrier gas and the diluent carrier gas.

Next, the ultrasonic vibrator 206 was vibrated at 2.4 MHz, and the vibration was propagated through the water 205a to the raw material solution 204a to form the raw material solution 204a into the mist to generate the mist. This mist was introduced into the film forming chamber 207 through the supply pipe 209 by the carrier gas, and the mist was thermally reacted on the underlying substrate 210 to form a thin film made of gallium oxide on the underlying substrate 210. The forming time was 120 minutes.

### (Evaluation)

Regarding the thin film obtained, the formation of α-Ga₂O₃ was confirmed by X-ray diffraction. In addition, a ω-2θ measurement was performed and in a state of capturing a peak attributable to the substrate, an angle ϕ was scanned, in which an angle ϕ was an angle around a ϕ axis orthogonal to a surface of the thin film, and then the ϕ was fixed where ϕ had a maximum detected intensity, and then each of 2Θ and w was scanned independently, resulting in a detection output (reflection output) reached maximum (local maximum point) when ω=24.14° and 2θ=32.28°. At this time, ω+θ was 40.28°.

### (Formation of First Metallic Layer (Schottky Electrode))

A Pt layer, a Ti layer, and an Au layer were laminated on an n⁻-type semiconductor layer by electron beam evaporation, respectively. Note that the Pt layer had a thickness of 10 nm, the Ti layer had a thickness of 4 nm, and the Au layer had a thickness of 175 nm.

### (Formation of Second Metallic Layer (Ohmic Electrode))

A Ti layer and an Au layer were laminated on an n⁺-type semiconductor layer by electron beam evaporation, respectively. Note that the Ti layer had a thickness of 35 nm, and the Au layer had a thickness of 175 nm.

### (Evaluation)

An IV measurement was performed on an SBD obtained. The yield was investigated in which a withstand voltage of 600V or higher was defined as acceptable, and then 88% of SBDs were acceptable.

### [Example 2]

Film formation, device production, and evaluation were performed using the same procedures as in Example 1 except that a sapphire substrate in which a detection output by X-ray diffraction was maximum at w=21.06° and 2θ=41.32° (ω+θ=41.72°) was used as an underlying substrate 210. X-ray diffraction showed that a detection output was maximum to an obtained n⁻ layer when ω=20.34° and 2θ=39.88°. In this case, ω+θ was 40.28°. When a withstand voltage yield was investigated, 82% was acceptable.

### [Example 3]

Film formation, device production, and evaluation were performed using the same procedures as in Example 1 except that a sapphire substrate in which a detection output by X-ray diffraction was maximum at ω=32.86°, 2θ=17.72° (ω+θ=41.72°) was used as an underlying substrate 210. X-ray diffraction showed that a detection output was maximum to an obtained n⁻ layer when ω=32.14° and 2θ=16.28°. In this case, ω+θ was 40.28°. When a withstand voltage yield was investigated, 80% was acceptable.

### [Example 4]

Film formation, device production, and evaluation were performed using the same procedures as in Example 1 except that a sapphire substrate in which a detection output by X-ray diffraction was maximum at ω=40.18° and 2θ=56.36° (ω+θ=68.36°) was used as an underlying substrate 210. X-ray diffraction showed that a detection output was maximum to an obtained n⁻ layer when ω=38.41° and 2θ=52.82°. In this case, ω+θ was 64.82°. When a withstand voltage yield was investigated, 90% was acceptable.

### [Example 5]

Film formation, device production, and evaluation were performed using the same procedures as in Example 1 except that a sapphire substrate in which a detection output by X-ray diffraction was maximum at ω=20.93° and 2θ=33.85° (ω+θ=37.86°) was used as an underlying substrate 210. X-ray diffraction showed that a detection output was maximum to an obtained n⁻ layer when ω=20.03° and 2θ=32.05°. In this case, ω+θ was 36.06°. When a withstand voltage yield was investigated, 83% was acceptable.

### [Example 6]

Film formation, device production, and evaluation were performed using the same procedures as in Example 1 except that a sapphire substrate in which a detection output by X-ray diffraction was maximum at ω=34.32° and 2θ=36.64° (ω+θ=52.64°) was used as an underlying substrate 210. X-ray diffraction showed that a detection output was maximum to an obtained n⁻ layer when ω=33.14° and 2θ=34.27°. In this case, ω+θ was 50.28°. When a withstand voltage yield was investigated, 85% was acceptable.

### [Comparative Example]

Film formation, device production, and evaluation were performed using the same procedures as in Example 1 except that a sapphire substrate in which a detection output by X-ray diffraction was maximum at ω=20.86° and 2θ=41.72° (ω+θ=41.72) was used as an underlying substrate 210. X-ray diffraction showed that a detection output was maximum to an obtained n⁻ layer when ω=20.14° and 2θ=40.28°. In this case, ω+θ was 40.28°. When a withstand voltage yield was investigated, 32% was acceptable.

### [Example 7]

Film formation, device production, and evaluation were performed using the same procedures as in Example 1 except that a lithium tantalate substrate in which a detection output by X-ray diffraction was maximum at ω=23.61° and 2θ=31.22° (ω+8=39.22°) was used as an underlying substrate 210. X-ray diffraction showed that a detection output was maximum to an obtained n⁻ layer when ω=24.14° and 2θ=32.28°. In this case, ω+θ was 40.28°. When a withstand voltage yield was investigated, 82% was acceptable.

### [Example 8]

Film formation, device production, and evaluation were performed using the same procedures as in Example 1 except that a sapphire substrate in which a detection output by X-ray diffraction was maximum at ω=34.40° and 2θ=67.92° (ω+θ=68.36°) was used as an underlying substrate 210. X-ray diffraction showed that a detection output was maximum to an obtained n⁻ layer when ω=32.63° and 2θ=64.38°. In this case, ω+θ was 64.82°. When a withstand voltage yield was investigated, 83% was acceptable.

### [Example 9]

Film formation, device production, and evaluation were performed using the same procedures as in Example 1 except that a sapphire substrate in which a detection output by X-ray diffraction was maximum at ω=46.13° and 2θ=44.46° (ω+θ=68.36°) was used as an underlying substrate 210. X-ray diffraction showed that a detection output was maximum to an obtained n⁻ layer when ω=44.36° and 2θ=40.92°. In this case, ω+θ was 64.82°. When a withstand voltage yield was investigated, 87% was acceptable.

### [Example 10]

Film formation, device production, and evaluation were performed using the same procedures as in Example 1 except that a sapphire substrate in which a detection output by X-ray diffraction was maximum at ω=19.22° and 2θ=37.26° (ω+θ=37.85°) was used as an underlying substrate 210. X-ray diffraction showed that a detection output was maximum to an obtained n⁻ layer when ω=18.32° and 2θ=35.46°. In this case, ω+θ was 36.05°. When a withstand voltage yield was investigated, 80% was acceptable.

### [Example 11]

Film formation, device production, and evaluation were performed using the same procedures as in Example 1 except that a sapphire substrate in which a detection output by X-ray diffraction was maximum at ω=30.91° and 2θ=13.88° (ω+θ=37.85°) was used as an underlying substrate 210. X-ray diffraction showed that a detection output was maximum to an obtained n⁻ layer when ω=30.01° and 2θ=12.08°. In this case, ω+θ was 36.05°. When a withstand voltage yield was investigated, 87% was acceptable.

### [Example 12]

Film formation, device production, and evaluation were performed using the same procedures as in Example 1 except that a sapphire substrate in which a detection output by X-ray diffraction was maximum at ω=26.59° and 2θ=52.10° (ω+θ=52.64°) was used as an underlying substrate 210. X-ray diffraction showed that a detection output was maximum to an obtained n⁻ layer when ω=25.41° and 2θ=49.73°. In this case, ω+θ was 50.27°. When a withstand voltage yield was investigated, 89% was acceptable.

### [Example 13]

Film formation, device production, and evaluation were performed using the same procedures as in Example 1 except that a sapphire substrate in which a detection output by X-ray diffraction was maximum at ω=38.28° and 2θ=28.72° (ω+θ=52.64°) was used as an underlying substrate 210. X-ray diffraction showed that a detection output was maximum to an obtained n⁻ layer when w=37.10° and 2θ=26.35°. In this case, ω+θ was 50.27°. When a withstand voltage yield was investigated, 82% was acceptable.

As shown above, acceptance yields of withstand voltage in all Examples were significantly higher than in Comparative Example. This indicates that the inventive crystalline oxide film is superior in withstand voltage.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A crystalline oxide film containing gallium as a main component, wherein when CuKα rays are made incident on the crystalline oxide film to perform X-ray diffraction,
a reflection output in scanning ω and 2Θ has a local maximum point when 16.20°<2θ<39.90° and 20.30°<ω<32.20° at an angle ϕ around a ϕ axis orthogonal to a surface of the crystalline oxide film at the angle ϕ where a peak attributable to the crystalline oxide film by ω-2θ measurement is maximum, and
40.10°<ω+θ<40.40° relative to ω and θ at which the reflection output reaches a maximum is satisfied.

2. A crystalline oxide film containing gallium as a main component, wherein when CuKα rays are made incident on the crystalline oxide film to perform X-ray diffraction,
a reflection output in scanning ω and 2Θ has a local maximum point when 26.20°<2Θ<49.90° and 25.30°<ω<37.20° at an angle ϕ around a ϕ axis orthogonal to a surface of the crystalline oxide film at the angle ϕ where a peak attributable to the crystalline oxide film by ω-2θ measurement is maximum, and
50.10°<ω+θ<50.40° relative to ω and θ at which the reflection output reaches a maximum is satisfied.

3. A crystalline oxide film containing gallium as a main component, wherein when CuKα rays are made incident on the crystalline oxide film to perform X-ray diffraction,
a reflection output in scanning ω and 2Θ has a local maximum point when 12.00°<2θ<35.70° and 18.20°<ω<30.10° at an angle ϕ around a ϕ axis orthogonal to a surface of the crystalline oxide film at the angle ϕ where a peak attributable to the crystalline oxide film by ω-2θ measurement is maximum, and
35.90°<ω+θ<36.20° relative to ω and θ at which the reflection output reaches a maximum is satisfied.

4. A crystalline oxide film containing gallium as a main component, wherein when CuKα rays are made incident on the crystalline oxide film to perform X-ray diffraction,
a reflection output in scanning ω and 2Θ has a local maximum point when 40.80°<2Θ<64.50° and 32.60°<ω<44.50° at an angle ϕ around a ϕ axis orthogonal to a surface of the crystalline oxide film at the angle ϕ where a peak attributable to the crystalline oxide film by ω-2θ measurement is maximum, and
64.70°<ω+θ<65.00° relative to ω and θ at which the reflection output reaches a maximum is satisfied.

5. The crystalline oxide film according to any one of claims 1 to 4, wherein
the crystalline oxide film has a surface area of 100 mm² or more or a diameter of 50 mm or more.

6. A laminated structure at least comprising:
an underlying substrate; and
the crystalline oxide film according to any one of claims 1 to 5.

7. A semiconductor device comprising the crystalline oxide film according to any one of claims 1 to 5.

8. A method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2Θ has a local maximum point when 17.70°<2θ<41.40° and 21.00°<ω<32.90° at an angle ϕ around a ϕ axis orthogonal to a surface of the underlying substrate at the angle ϕ where a peak attributable to the underlying substrate by ω-2θ measurement is maximum, and
41.60°<ω+θ<41.90° relative to ω and θ at which the reflection output reaches a maximum is satisfied.

9. A method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2Θ has a local maximum point when 28.60°<2Θ<52.30° and 26.50°<ω<38.40° at an angle ϕ around a ϕ axis orthogonal to a surface of the underlying substrate at the angle ϕ where a peak attributable to the underlying substrate by ω-2θ measurement is maximum, and
52.50°<ω+θ<52.80° relative to ω and θ at which the reflection output reaches a maximum is satisfied.

10. A method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2θ has a local maximum point when 13.80°<2θ<37.50° and 19.10°<w<31.00° at an angle ϕ around a ϕ axis orthogonal to a surface of the underlying substrate at the angle ϕ where a peak attributable to the crystalline oxide film by ω-2θ measurement is maximum, and
37.70°<ω+θ<38.00° relative to ω and θ at which the reflection output reaches a maximum is satisfied.

11. A method for producing a crystalline oxide film containing gallium as a main component, the method comprising forming the crystalline oxide film on a sapphire substrate as an underlying substrate, wherein
when CuKα rays are made incident on the underlying substrate to perform X-ray diffraction,
a reflection output in scanning ω and 2θ has a local maximum point when 44.30°<2θ<68.00° and 34.30°<ω<46.20° at an angle ϕ around a ϕ axis orthogonal to a surface of the underlying substrate at the angle ϕ where a peak attributable to the crystalline oxide film by ω-2θ measurement is maximum, and
68.20°<ω+θ<68.50° relative to ω and θ at which the reflection output reaches a maximum is satisfied.
